Europäisches Patentamt

European Patent Office

Office européen des brevets

(19)

(11) Veröffentlichungsnummer: **0 225 396 B1**

(12) **EUROPÄISCHE PATENTSCHRIFT**

(45) Veröffentlichungstag der Patentschrift:
26.09.90

(21) Anmeldenummer: 85115842.8

(22) Anmeldetag: 12.12.85

(51) Int. Cl.⁵: **G01R 25/08**

(54) **Digitale Phasenmesschaltung.**

(43) Veröffentlichungstag der Anmeldung:
16.06.87 Patentblatt 87/25

(45) Bekanntmachung des Hinweises auf die Patenterteilung:
26.09.90 Patentblatt 90/39

(84) Benannte Vertragsstaaten:
DE FR GB IT NL

(56) Entgegenhaltungen:
EP-A- 0 043 407
EP-A- 0 122 491
US-A- 4 025 848

(73) Patentinhaber: **Deutsche ITT Industries GmbH,
Hans-Bunte-Strasse 19 Postfach 840,
D-7800 Freiburg(DE)**

(72) Erfinder: **Mehrgardt, Sönke, Dr., Häglestrasse 26,
D-7801 March(DE)**

ACTORUM AG

## Beschreibung

Aus der EP-A1-0 122 491 ist eine digitale Phasenmeßschaltung zum Ermitteln der Phasendifferenz zwischen der Flanke eines Impulses eines ersten Taktsignals und der Flanke eines Impulses eines zweiten Taktsignals im Abtastintervall zweier Impulse des zweiten Taktsignals bekannt. Bei dieser Phasenmeßschaltung wird nach einem Ausführungsbeispiel der Impuls eines ersten Taktsignals aus dem Zeilenrücklaufimpuls der Horizontal-Ablenkschaltung eines Fernsehempfängers abgeleitet und die Phasendifferenz zu einem Impuls eines zweiten Taktsignals ermittelt, das aus dem senderseitig erzeugten Phasenvergleichsimpuls abgeleitet wird. Die bekannte Phasenmeßschaltung enthält einen A/D-Wandler, der mit einem Vielfachen der Zeilenrücklaufimpulsfolgefrequenz getaktet werden muß, und einen dem A/D-Wandler nachschaltbaren Multiplizierer, der umschaltbar ist, und einen getakteten Integrator.

Die Erfindung betrifft eine solche digitale Phasenmeßschaltung gemäß dem Oberbegriff des Anspruchs 1.

Aufgabe der Erfindung ist die Angabe einer solchen digitalen Phasenmeßschaltung, welche monolithisch integrierbar ist und einen geringeren Schaltungsaufwand als die bekannte zur Begrenzung des Flächenbedarfs bei der Integration aufweist.

Die Aufgabe wird erfindungsgemäß durch die im kennzeichnenden Teil des Anspruchs 1 angegebene Schaltungsanordnung gelöst.

Es ist vorteilhaft, die digitale Phasenmeßschaltung nach der Erfindung mit m Verzögerungsgliedern, m Registerzellen, m XOR-Gattern (exclusive ODER-Gatter) und mit einem Vielfachaddierer auszustatten, dessen Ausgang ein n-stelliges Binärsignal liefert, wobei $m = 2^n$ und n ganzzahlig ist. In diesem Falle liefert der Ausgang des Vielfachaddierers bei Interpretation seines Ausgangssignals als Binärbruch unmittelbar den Digitalwert der relativen Lage der Flanken der Impulse des ersten Taktsignals zur Flanke eines Impulses des zweiten Taktsignals im Abtastintervall zweier Impulse des zweiten Taktsignals.

Da als Komponenten der digitalen Phasenmeßschaltung nach der Erfindung bekannte integrierbare Schaltungen verwendet werden, nämlich ein Frequenzteiler, eine Verzögerungsleitung bekannten Aufbaues, bekannte Register, ein Vielfachaddierer und die XOR-Gatter, deren Realisierung bekannt ist, erübrigt sich eine diesbezügliche Beschreibung dieser Schaltungskomponenten. Beispielsweise könnten XOR-Gatter nach der PCT-Veröffentlichung WO 85/02957 verwendet werden.

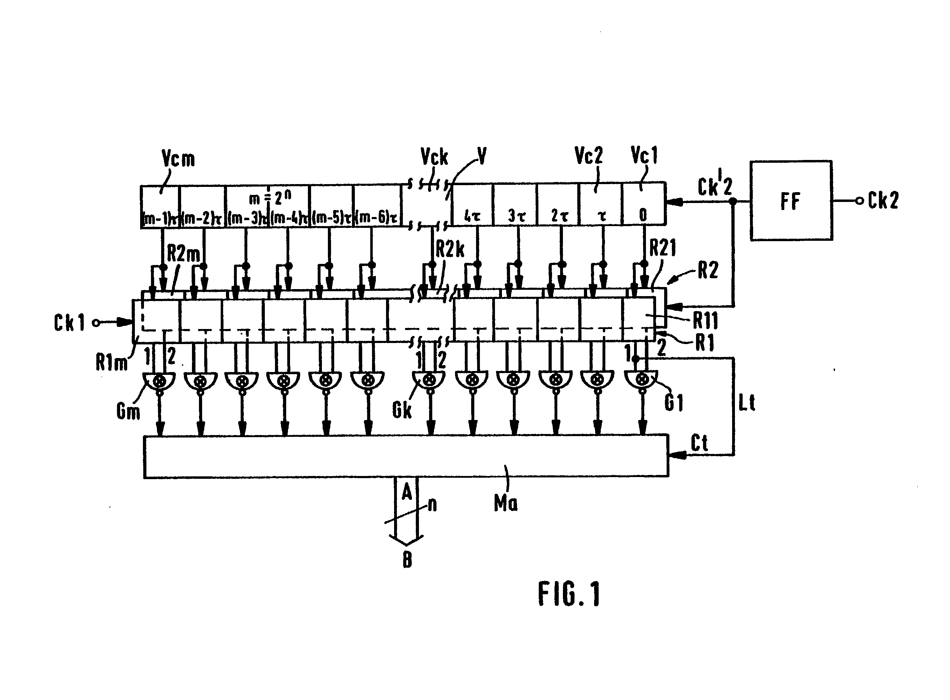

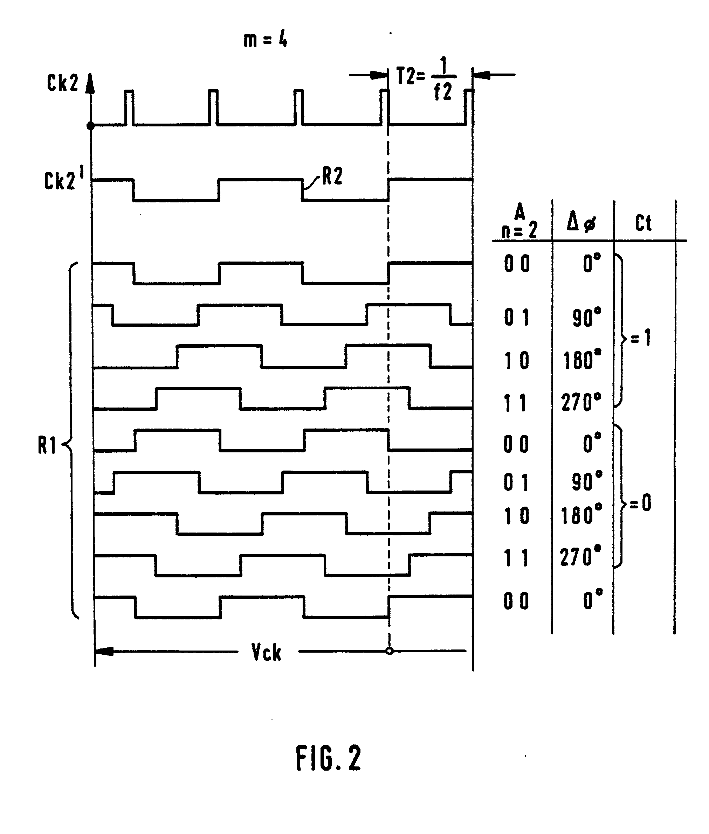

Die Erfindung und ihre Vorteile werden im folgenden anhand der Zeichnung erläutert,

deren Fig. 1 das Blockschaltbild der digitalen Phasenmeßschaltung nach der Erfindung zeigt und
deren Fig. 2 zur Erläuterung der Funktionsweise der digitalen Meßschaltung nach der Erfindung dient.

Die Fig. 1 zeigt das Blockschaltbild der digitalen Phasenmeßschaltung nach der Erfindung, welche mit relativ geringem Aufwand an Kristallfläche monolithisch integrierbar ist. Das Taktsignal Ck2 liegt am Eingang des Frequenzteiler-Schaltkreises FF, beispielsweise eines JK-Flipflops, und wird über diesen in die Verzögerungsleitung V eingespeist. Diese besteht aus m Verzögerungsgliedern Vc1... Vcm der Verzögerungszeit $\tau$. Bei der Anwendung der Erfindung in Fernsehempfängern liegt die Verzögerungszeit günstig im Bereich von 1,5 ns bis 3,5 ns. Der Inhalt der Verzögerungsleitung V wird synchron zum zweiten Taktsignal Ck2 in die Reihe von m Registerzellen R21... R2m des zweiten Registers R2 gespeichert. Damit enthält das zweite Register R2 stets ein Referenzsignal, welches in den einzelnen Registerzellen R21 bis R2m gespeichert ist. Der Takteingang des zweiten Registers R2 liegt ebenfalls am Ausgang des Frequenzteilers-Schaltkreises FF, während die Registerzellen R11 bis R1m des ersten Registers R1 vom ersten Taktsignal Ck1 getaktet werden, wodurch jeweils der Inhalt der Verzögerungsleitung V in das erste Register R1 eingeschrieben wird.

Die digitale Phasenmeßschaltung nach der Erfindung weist ferner eine Reihe von m XOR-Gatter G1 bis Gm auf, bei denen der Reihe nach der erste Eingang 1 des k-ten XOR-Gatters Gk mit dem Ausgang der entsprechenden k-ten Registerzelle R1k des ersten Registers R1 und der Reihe nach jeweils der zweite Eingang 2 mit dem Ausgang der entsprechenden k-ten Registerzelle R2k des zweiten Registers R2 verbunden sind. Dabei liegen die Eingänge der k-ten Registerzellen sowohl des ersten Registers R1 als auch des zweiten Registers R2 am Ausgang des entsprechenden k-ten Verzögerungsgliedes Vck, wie aus der Fig. 1 ersichtlich ist.

Die Ausgänge der Register R1 und R2 sind somit paarweise durch je ein XOR-Gatter verknüpft. Die Gatter G1 bis Gm liefern also die logische Eins, wenn ihre Eingangssignale unterschiedlich sind.

Die digitale Phasenmeßschaltung nach der Erfindung enthält ferner den Vielfachaddierer Ma, der vorteilhaft in bekannter Weise in Baum-Struktur ("carry-save adder") realisiert wird. Der Vielfachaddierer weist m Eingänge auf und liefert ein n-stelliges binäres Ausgangssignal, wobei die m Eingänge einzeln mit den einzelnen Ausgängen der XOR-Gatter G1 bis Gm verbunden sind. Der Vielfachaddierer Ma zählt also die Anzahl der logischen Einsen, welche Anzahl offensichtlich Null ist, wenn alle Eingänge der Gatter G1 bis Gm gleich sind, was bei Phasengleichheit der Taktsignale Ck1 und Ck2 der Fall ist.

Der Vielfachaddierer Ma erhält ferner noch ein Steuersignal Ct über die Leitung Lt, welches am Eingang 1 des ersten XOR-Gatters G1 bzw. am ersten Ausgang des ersten Verzögerungsgliedes Vc1 liegt, also der Verzögerungszeit "Null" zugeordnet ist.

Ist nun X die Anzahl von logischen Einsen an den Eingängen des Vielfachaddierers Ma, dann gilt für das binäre Signal B am Ausgang A:
B = X, falls Ct = 1
B = m - X falls Ct = 0.

Wie bereits erwähnt, ist es vorteilhaft, die Anzahl m der Verzögerungsglieder der Verzögerungsleitung V bzw. die Anzahl der Registerzellen der Register R1, R2 und die Anzahl der XOR-Gatter G1 bis Gm entsprechend der Beziehung $m = 2^n$ zu wählen, wobei die Stellenzahl des Ausgangs des Vielfachaddierers gleich n ist und der Überlauf, beispielsweise im Falle von X = 0, m - 0 = m unberücksichtigt bleibt. Bei Interpretation als n-stelliger Binärbruch liefert der Vielfachaddierer Ma somit gerade das gewünschte Ergebnis, nämlich die relative Lage der Flanke eines Impulses des Taktimpulses Ck1 im Abtastintervall des Taktimpulses Ck2.

Die Fig. 2 zeigt einige typische Zustände einer solchen digitalen Phasenmeßschaltung mit m = 4 und damit n = 2 und die sich ergebenden Digitalwerte am Ausgang A des Vielfachaddierers Ma. Fig. 2 veranschaulicht die Wirkungsweise des Frequenzteiler-Schaltkreises FF, an dessen Eingang der Taktimpuls Ck2 liegt und dessen Ausgang den Taktimpuls Ck2' bildet, der am Eingang der Verzögerungsleitung V liegt und der das zweite Register R2 taktet. Fig. 2 veranschaulicht ferner, welche Ausgangssignale am Ausgang A des Vielfachaddierers erhalten werden, falls die Phasenlage 0°, 90°, 180° oder 270° beträgt.

Für praktische Anwendungen beim digitalen Fernsehen ist $m = 2^6 = 64$ ausreichend. Die Verzögerungsleitung besteht aus nichtgetakteten Gattern.

Für die Realisierung der digitalen Phasenmeßschaltung nach Fig. 1 in einer 3μ-HMOS-Technologie, d.h. mit Leiterbahnenbreiten von 3 μm, ist eine Fläche von etwa 1.7 mm² erforderlich.

## Patentansprüche

1. Digitale Phasenmeßschaltung zum Ermitteln der Phasendifferenzen zwischen der Flanke eines Impulses eines ersten Taktsignals (Ck1) und der Flanke eines Impulses eines zweiten Taktsignals (Ck2) innerhalb des Abtastintervalls zweier Impulse des zweiten Taktsignals (Ck2), gekennzeichnet
- durch einen Frequenzteiler-Schaltkreis (FF),
  - - an dessen Eingang das zweite Taktsignal (Ck2) liegt und dessem Ausgang mit dem Eingang einer eine Reihe von m Verzögerungsgliedern (Vc1...Vcm) aufweisenden Verzögerungsleitung (V) und mit dem Takteingang eines zweiten Registers (R2), welches eine Reihe von m Registerzellen R21...R2m enthält, verbunden ist, welche jeweils von dem am Ausgang des Frequenzteiler-Schaltkreises (FF) auftretenden Signal getaktet sind,
- durch ein erstes Register (R1) mit ebenfalls einer Reihe von m Registerzellen (R11...R1m), welche vom ersten Taktsignal (Ck1) getaktet sind,
- durch eine Reihe von m XOR-Gattern (G1...Gm), bei denen der Reihe nach der erste Eingang (1) des k-ten XOR-Gatters (Gk) mit dem Ausgang der entsprechenden k-ten Registerzelle (R1k) des ersten Registers (R1) und der Reihe nach jeweils der zweite Eingang (2) mit dem Ausgang der entsprechenden k-ten Registerzelle (R2k) des zweiten Registers (R2) verbunden sind, während die Eingänge der k-ten Registerzellen sowohl des ersten Registers (R1) als auch des zweiten Registers (R2) am Ausgang des entsprechenden k-ten Verzögerungsgliedes (Vck) liegen,
- durch einen über eine Leitung (Lt) gesteuerten Vielfachaddierer(Ma), der ein n-stelliges Ausgangssignal (B) liefert und der m Eingänge aufweist, die einzeln mit den einzelnen Ausgängen der XOR-Gatter (G1...Gm) verbunden sind, und
- durch eine Verbindung der Leitung (Lt) mit dem Ausgang der ersten Registerzelle (R11) des ersten Registers (R1).
2. Digitale Phasenmeßschaltung nach Anspruch 1, gekennzeichnet durch m Verzögerungsglieder, m Registerzellen und m XOR-Gatter, wobei m gleich $2^n$ und n ganzzahlig ist.

## Claims

1. Digital phase meter circuit for determining the phase differences between the edge of a pulse of a first clock signal (Ck1) and the edge of a pulse of a second clock signal (Ck2) within the sampling interval of two pulses of the second clock signal (Ck2), characterized
  - by a frequency-divider circuit (FF),
    - whose input is supplied with the second clock signal (Ck2), and whose output is coupled to the input of a delay line (V) consisting of a row of m delay elements (Vc1...Vcm) and to the clock input of a second register (R2) containing a row of m cells (R21...R2m) each of which is clocked by the signal provided at the output of the frequency-divider circuit (FF),
  - by a first register (R1) containing a row of m cells (R11...R1m) clocked by the first clock signal (Ck1),
  - by a row of m XOR gates (G1...Gm) in which the first input (1) of the kth XOR gate (Gk) is connected to the output of the corresponding kth cell (R1k) of the first register (R1), and the second input (2) to the output of the corresponding kth cell (R2k) of the second register (R2) whereas the inputs of the kth cells of both the first register (R1) and the second register (R2) are connected to the output of the corresponding kth delay element (Vck),
  - by a multiple adder (Ma) which is controlled over a line (Lt), delivers an n-bit output signal (B), and has m inputs each connected to the output of one of the XOR gates (G1...Gm), and
  - by a connection between a line (Lt) and the output of the first cell (R11) of the first register (R1).
2. A digital phase meter circuit as claimed in claim 1, characterized by m delay elements, m register cells, and m XOR gates, where m is equal to $2^n$, and n is an integer.

## Revendications

1. Circuit numérique de mesure de la phase, servant à déterminer les différences de phase entre le flanc d'une impulsion d'un premier signal de cadence (Ck1) et le flanc d'une impulsion d'un second signal de cadence (Ck2) pendant l'intervalle d'échantillonnage entre deux impulsions du second signal de cadence (Ck2), caractérisé
- par un circuit diviseur de fréquence (FF),
-- à l'entrée duquel est appliqué le second signal de cadence (Ck2) et dont la sortie est reliée à l'entrée d'une ligne à retard (V) comportant une série de m circuits de retardement (Vc1...Vcm), et à l'entrée de cadence d'un second registre (R2), qui contient une série de m cellules (R21...R2m), qui sont commandées respectivement de façon cadencée par le signal apparaissant à la sortie du circuit diviseur de fréquence (FF),
- par un premier registre (R1) comportant également une série de m cellules (R11...R1m), qui sont commandées de façon cadencée par le premier signal de cadence (Ck1),
- par une série de m portes OU-Exclusif (G1...Gm), dans lesquelles, successivement, la première entrée (1) de la k-ème porte OU-Exclusif (Gk) est reliée à la sortie de la k-ème cellule correspondante (R1k) du premier registre (R1) et, successivement, respectivement la seconde entrée (2) est reliée à la sortie de la k-ème cellule correspondante (R2k) du second registre (R2), tandis que les entrées des k-èmes cellules aussi bien du premier registre (R1) que du second registre (R2) sont raccordées à la sortie du k-ème circuit de retard correspondant (Vck),
- par un additionneur multiple (Ma), qui est commandé par l'intermédiaire d'une ligne (Lt), fournit un signal de sortie (B) à n éléments et possède m entrées, qui sont reliées individuellement aux différentes sorties des portes OU-Exclusif (G1...Gm), et
- par une liaison de la ligne (Lt) à la sortie de la première cellule (R11) du premier registre (R1).

2. Circuit numérique de mesure de la phase selon la revendication 1, caractérisé par m circuits de retardement, m cellules de registre et m portes OU-Exclusif, m étant égal à $2^n$ et n étant un nombre entier.

FIG.1

m = 4

Ck2

$T2 = \dfrac{1}{f2}$

Ck2'

R2

R1

Vck

| $\overset{A}{n=2}$ | $\Delta\phi$ | Ct |
|---|---|---|
| 0 0 | 0° | |
| 0 1 | 90° | |
| 1 0 | 180° | = 1 |
| 1 1 | 270° | |
| 0 0 | 0° | |
| 0 1 | 90° | |
| 1 0 | 180° | = 0 |
| 1 1 | 270° | |
| 0 0 | 0° | |

FIG. 2